# EUROPÄISCHE PATENTANMELDUNG

(11) **EP 4 044 217 A1**
(43) Veröffentlichungstag der Anmeldung: **17.08.2022**
(21) Anmeldenummer: 21156215.2
(22) Anmeldetag: 10.02.2021
(51) Int. Cl.: H01L 21/67, H01L 21/687, H01L 21/677, H01L 21/68

(54) **VERFAHREN UND VORRICHTUNG ZUM MARKIEREN VON DEFEKTEN AUF EINER OBERFLÄCHE EINER HALBLEITERSCHEIBE**

(71) Anmelder: Siltronic AG, 81677 München (DE)
(72) Erfinder: Ehlert, Andreas, 84547 Emmerting (DE)

(57) **Zusammenfassung**

Verfahren zum Markieren von Defekten auf einer Oberfläche einer Halbleiterscheibe, das die folgenden Schritte umfasst:
Identifizieren einer Markierungsstelle auf der Oberfläche einer Halbleiterscheibe und Markieren einer Oberfläche der Halbleiterscheibe mit einer Vielzahl von Referenzmarkierungen mit einer Tiefe d und einem Öffnungswinkel α in einem vordefinierten Muster um die Markierungsstelle unter Zuhilfenahme eines Markierungswerkzeuges,
wobei die Markierungsstelle einer Position eines Defekts auf der Oberfläche der Halbleiterscheibe entspricht und das Identifizieren der Markierungsstelle das Bereitstellen einer Defektdatei, die eine Liste ungefährer Positionen einer Vielzahl von Defekten auf der Halbleiterscheibe beinhaltet, und ein Anfahren eines Objektivs einer ungefähren Position eines Defekts für eine mikroskopische Analyse umfasst, wobei die mikroskopische Analyse die Schritte (1) Erzeugung eines ersten Bildes und (2) Analysieren des ersten Bildes mit Methoden einer elektronischen Bildverarbeitung, mit dem Ziel, eine genauere Position des Defektes zu erhalten, enthält, wobei die Erzeugung des ersten Bildes mittels eines Rasterkraftmikroskops (AFM) durchgeführt wird.

## Beschreibung

Die vorliegende Erfindung bezieht sich auf ein Verfahren zur Klassifizierung von kleinen Fremdpartikeln auf Halbleiterscheiben.

Monokristalline Halbleiterscheiben (auch Wafer genannt) sind die Grundlage der modernen Elektronik. Während der Herstellung von Bauelementen auf besagten Halbleiterscheiben werden thermische Prozesse und mittlerweile recht komplexe Beschichtungsschritte durchgeführt.

Die Identifizierung von Defekten auf der Oberfläche einer Halbleiterscheiben, wie z.B. partikuläre Verunreinigungen und andere Oberflächenunregelmäßigkeiten, ist für die Herstellungsprozesse integrierter Schaltkreise äußerst wichtig. Um Fehlerquellen zu eliminieren, werden Defekte identifiziert und analysiert, um die Fehlerquelle zu identifizieren. Danach können Korrekturmaßnahmen ergriffen werden, um die Fehlerquellen zu reduzieren oder zu beseitigen.

Als Standardverfahren zur Detektion von Oberflächendefekten auf Siliziumwafern gelten Messverfahren, welche auf dem Prinzip der Lichtstreuung basieren. Diese Streulichtmess-Systeme liefern u.a. Informationen über die Position der Defekte auf der Waferoberfläche sowie deren Größe. Diese Information wird in der Regel in elektronischer Form gespeichert, zumeist in einem standardisierten Industrieformat (KIa Review File Format, KLARFF) und steht für nachfolgende analytische Messungen der Wafer zur Verfügung.

Das Ergebnis einer Lichtstreumessung reicht aber in der Regel nicht aus, um Aussagen über die Ursachen des gefundenen Defektes treffen zu können.

Üblicherweise wird daher der Prozess der Fehleridentifizierung in zwei Schritten durchgeführt. Zunächst scannt ein Laserscannergerät einen Wafer mit einem Laser und analysiert die Rückstreuung des Lasers, um Defekte auf der Oberfläche des Wafers zu lokalisieren. Zweitens wird jeder durch den Scanner lokalisierte Defekt analysiert, um die Grundursache des Defekts zu identifizieren.

Das am häufigsten verwendete Analysewerkzeug ist ein Abbildungssystem mit hoher Vergrößerung, wie z.B. ein Rasterelektronenmikroskop (REM). Ein REM wird verwendet, um den Defekt und/oder die Defektquelle zu identifizieren, indem der Defekt bei hoher Vergrößerung untersucht wird. Zusätzlich kann das REM von Instrumenten zur Durchführung einer chemischen Analyse des Defekts begleitet werden. Eine solche Instrumentierung umfasst einen energiedispersiven Röntgendetektor (EDX-Detektor). Andere Instrumente können Instrumente zur Durchführung einer Auger-Analyse, ein Rasterkraftmikroskop (AFM), ein Transmissionselektronenmikrosokop (TEM), ein optisches Spektrometer und ähnliches umfassen.

### Problembeschreibung

Üblich ist, mit Hilfe von Lichtstreuung gefundene Defekte auf der Oberfläche von Halbleiterscheiben geeignet zu markieren, um sie in den anschießenden mikroskopischen Messungen wieder zu finden. Im Markieren von besonders kleinen Defekten liegt die Herausforderung, die es zu meistern gilt, ohne dabei zusätzliche Kontaminationen oder auch Beschädigungen zu verursachen.

Die Aufgabe besteht also darin, ein Verfahren und eine Vorrichtung zum Markieren von Defekten zur Verfügung zu stellen, die kleinste Defekte auf Halbleiterscheiben zu markieren vermögen, ohne dabei zusätzliche Kontaminationen der zu untersuchenden Proben zu verursachen oder die Probe zu beschädigen.

Gelöst wird die Aufgabe durch das Verfahren zum Markieren von Defekten auf einer Oberfläche einer Halbleiterscheibe, das die folgenden Schritte umfasst: Identifizieren einer Markierungsstelle auf der Oberfläche der Halbleiterscheibe und Markieren der Halbleiterscheibe mit einer Vielzahl von Referenzmarkierungen mit einer Tiefe d und einem Öffnungswinkel α in einem vordefinierten Muster in der Nähe der Markierungsstelle, wobei die Markierungsstelle eine Position eines Defekts auf der Oberfläche der Halbleiterscheibe ist und der Identifizierungsschritt das Bereitstellen einer Defektdatei, die eine Liste ungefährer Positionen einer Vielzahl von Defekten auf der Halbleiterscheibe beinhaltet, und ein Anfahren einer ungefähren Position eines Defekts für eine mikroskopische Analyse umfasst, wobei die mikroskopische Analyse die Schritte (1) Erzeugung eines ersten Bildes und (2) Analysieren des ersten Bildes mit Methoden einer Bildverarbeitung, mit dem Ziel, eine genauere Position des Defektes zu erhalten, enthält, dadurch gekennzeichnet, dass die Erzeugung des ersten Bildes mittels eines Rasterkraftmikroskops (AFM) durchgeführt wird.

Ebenfalls gelöst wird die Aufgabe durch eine Vorrichtung zum Anbringen von Markierungen auf einer Halbleiterscheibe enthaltend eine Aufnahmestation für eine Wafer-Kassette, eine Haltevorrichtung zum Transportieren von Halbeiterscheiben eine Einheit zur Ablage einer Halbleiterscheibe und eine Vorrichtung zum Indentieren, dadurch gekennzeichnet, dass die Einheit zur Ablage einer Halbleiterscheibe beinhaltet eine Scheibe mit einer im wesentlichen kreisförmigen Oberfläche mit einem Durchmesser D und einer Umfangsfläche der Höhe h, wobei die Umfangsfläche an drei Bereichen durch jeweils eine Einbuchtung unterbrochen ist, an der sich jeweils eine Haltevorrichtung für eine Halbleiterscheibe befindet, deren Auflagefläche einen Abstand zur kreisförmigen Oberfläche aufweist, so dass eine aufgelegte Halbleiterscheibe nicht die kreisförmige Oberfläche berühren kann.

### Stand der Technik

Als Standardverfahren zur Analyse von Defekten auf Waferoberflächen werden u.a. die optische Mikroskopie, Elektronenmikroskopie (SEM) mit verknüpften Analysatoren (z.B. EDS, Auger), spektroskopische Verfahren wie µ-Raman oder die Rasterkraftmikroskopie (AFM) angesehen. (siehe z.B. C. Brundle, CP449, Characterization and Metrology for ULSI Technology, 1998 Int. Conference, 677 ff). Vorrichtungen, die diese Verfahren durchführen werden als "Review-Stationen" bezeichnet.

Die Review-Stationen können ganze Wafer nach dem "Cassette-to-Cassette"-Prinzip aufnehmen und rezeptbasiert die Wafer an den für jeweiligen den Zweck interessanten Positionen analysieren.

Review-Stationen nutzen in der Regel standardisierte Datenformate, die von den Streulichtmess-Systemen zur Verfügung gestellt werden.

Es ist bekannt, dass zwischen den Streulichtmess-Systemen und den Review-Stationen ein sogenannter "Offset" (sowohl lateral als auch azimutal) bezüglich der Koordinaten existiert. Die verwendeten Koordinaten sind also ungenau. Verursacht wird dies unter anderem durch mechanisch voneinander abweichende Waferhalter in den jeweiligen Systemen.

Review-Stationen können diesen Mangel umgehen, indem sie zum Beispiel einen Suchlauf im sog. "Spiral Search Mode" um die vermutete Defektposition durchführen, bis der Defekt im Abbildungsfenster des jeweiligen Messsystems gefunden wird. Auf ein vorheriges Markieren von Defekten kann bei der Nutzung von Review-Stationen verzichtet werden. Dies ist jedoch äußerst zeitaufwendig.

Bei anderen Messverfahren wie der optischen Mikroskopie, µRaman und weitere sind keine Review Stationen kommerziell verfügbar.

Die durchzuführende Defektanalytik muss zudem teilweise auch an Wafer Bruchstücken durchgeführt werden. Ein oben beschriebener Suchlauf ist hier nicht möglich, deshalb ist ein geeignetes Markieren von Defekten gerade auch in diesen Fällen essenziell.

Zur Markierung von lokalen Defekten vor der eigentlichen Analyse wird in C. Brundle et al eine Apparatur beschrieben (CP449, Characterization and Metrology for ULSI Technology, 1998 Int. Conference, 677 ff) bei der mittels eines Lasers eine Art Hilfsmarkierung auf die zu untersuchende Probe aufgebracht wird. Diese Hilfsmarkierung erleichtert dann später bei der eigentlichen Analyse mit den vorher beschriebenen Methoden die Auffindung der lokalen Defekte.

Die dort beschriebene Vorrichtung besitzt einige Nachteile, die den Einsatz bei der aktuellen und zukünftigen Generation von Halbleiterscheiben verbietet:
(1) Durch Laser induzierte Markierungen weisen einen Kontaminationshof um die Lasermarkierung auf.
(2) Die Größe und die Geometrie der Markierungen führen bei der Erfassung der Koordinaten zu Ungenauigkeiten.
(3) Die zu untersuchende Probe erfährt zusätzliche Querkontamination und/oder der Kontakt mit der dafür verwendeten optischen Bank führt sogar zu einer Beschädigung der Probenoberfläche

Wegen dieser Nachteile können so markierte Proben nicht mehr in Reinraumbereichen bzw. auf dort angeordneten Messgeräten zurückgeschleust werden, zumindest ist das Analyseergebnis ungeeignet für weitergehende Analysen. Damit fallen viele Analysemethoden aus, die hilfreich wären, Defektursachen einfach zu finden.

In der Patentschrift EP 0 877 413 A2 werden sowohl eine Vorrichtung als auch ein Verfahren beschrieben, bei denen ein optisches Mikroskop mit einer Markierungsvorrichtung (einem sogenannten "Indenter") gekoppelt werden.

In der Nähe eines im optischen Mikroskop gefundenen Defekts wird mittels einer Spitze (dem "Indenter") ein kleiner mechanische Eindruck hinterlassen, der später einfach wiedergefunden werden kann. Um den entsprechenden Gegendruck zu kompensieren liegt dabei die Halbleiterscheibe auf einer flächigen Auflage auf.

Mit dieser Vorrichtung können auf der Halbleiterscheibe entweder einzelne Defekte markiert und/oder ein Markierungsmuster auf die Halbleiterscheibe aufgebracht werden. Das Markierungsmuster kann in nachfolgenden Prozessschritten wie z.B. einer weiteren Vermessung als Referenz für die Auswertung des Wafers verwendet werden.

Der in EP 0 877 413 A2 beschriebene Ablauf hat jedoch den Nachteil, dass der Wafer flächig auf einer Auflage abgelegt wird und es damit zu einer Kreuzkontamination oder sogar zu einer Beschädigung der zu messenden Probe kommen kann.

Zudem ist das darin beschriebene optische Mikroskop hinsichtlich seiner Auflösung beschränkt und daher nicht in der Lage, zwei nahe beieinanderliegende Defekte unterhalb der optischen Auflösungsgrenze zu unterscheiden.

### Beschreibung der Figuren

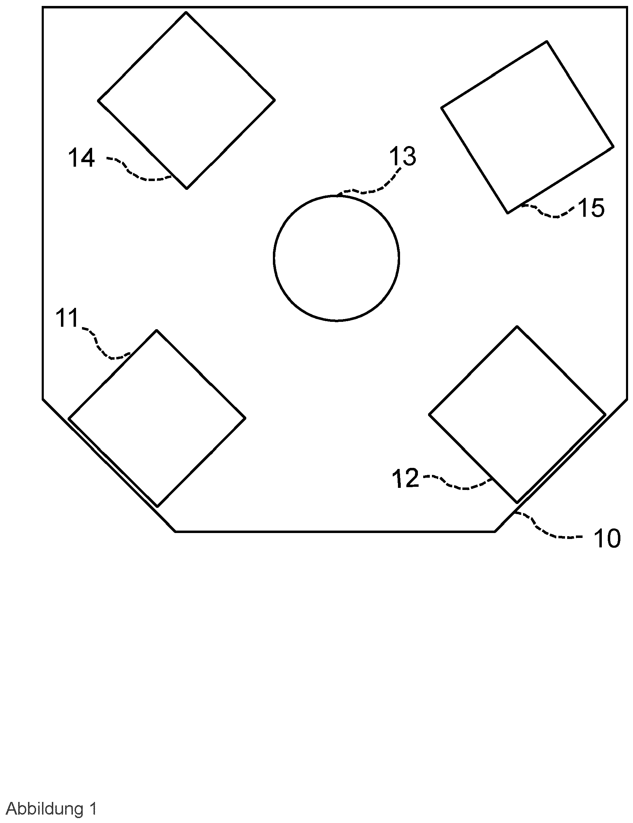

**Abbildung 1** zeigt eine beispielhafte Anordnung einer erfindungsgemäßen Ausprägung einer Vorrichtung zum Anbringen von Markierungen auf einer Oberfläche einer Halbleiterscheibe. In einem Gehäuse (**10**) sind zwei Vorrichtungen zur Aufnahme für einer Wafer-Kassetten ((**11**) und (**12**)) angebracht, so dass sie von außen gut mit jeweils einer Wafer-Kassette beschickt werden können. In der Mitte des Gehäuses befindet sich eine Vorrichtung zum automatischen Transportieren von einzelnen Halbeiterscheiben (**13**), der idealerweise als Roboterarm ausgeführt ist, dessen Aufgabe es ist, die Halbleiterscheiben einzeln sicher aus einer Wafer-Kassette (**12 oder 11**) zu nehmen, und sie wieder in einer Wafer-kassette (**11 oder 12**) abzulegen. Ferner befindet ist innerhalb des Gehäuses eine Vorrichtung zum Markieren einer Oberfläche einer Halbleiterscheibe unter Verwendung eines Eindrückwerkzeugs (**15**) ebenso eine Vorrichtung zum Ausrichten der Halbleiterscheibe ("Aligner") (**14**).

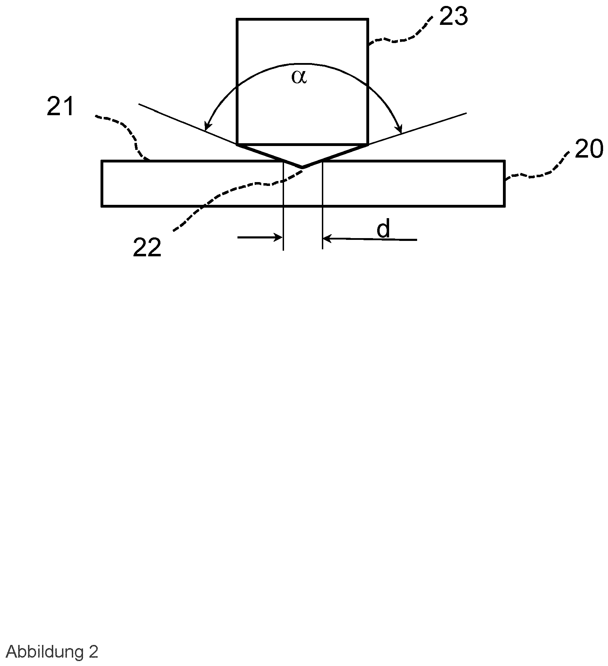

**Abbildung 2** zeigt die erfindungsgemäß verwendete Eindrückwerkzeug (**23**), das eine Spitze (**22**) mit einem Öffnungswinkel α aufweist. Das Eindrückwerkzeug bewirkt durch das Eindrücken auf eine Oberfläche (**21**) einer Halbleiterscheibe (**20**) einen Eindruck mit einem Durchmesser **d.**

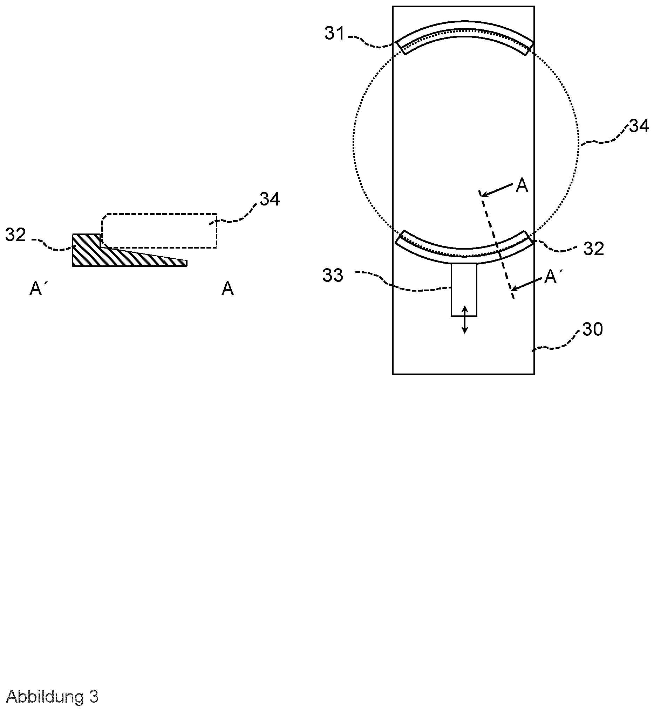

**Abbildung 3** zeigt eine Vorrichtung zum Transportieren von Halbleiterscheiben, die zweckmäßigerweise an den Roboterarm angebracht wird. Die Vorrichtung beinhaltet dabei eine Grundplatte (**30**), ein erstes profiliertes Kreissegment (**31**) und ein zweites profiliertes Kreissegment (**32**). Die beiden Kreissegmente (**31** und **32**) sind dabei so auf einer Grundplatte (**30**) angebracht, dass sie einen gemeinsamen Kreismittelpunkt haben. Es ist zweckmäßig ein Kreissegment (**32**) an einer Vorrichtung (**33**) zu befestigen, die eine laterale Bewegung zulässt, um so eine Feinabstimmung auf den Durchmesser der Halbleiterscheibe (**34**) zu bewirken.

Ein Profil eines Kreissegmentes ist so ausgeprägt, dass es eine Ablagefläche aufweist, auf dem eine Halbleiterscheibe (**34**) abgelegt werden kann. Der Schnitt A-A' in **Abbildung 3** durch ein profiliertes Kreissegment (**32**) soll dies verdeutlichen.

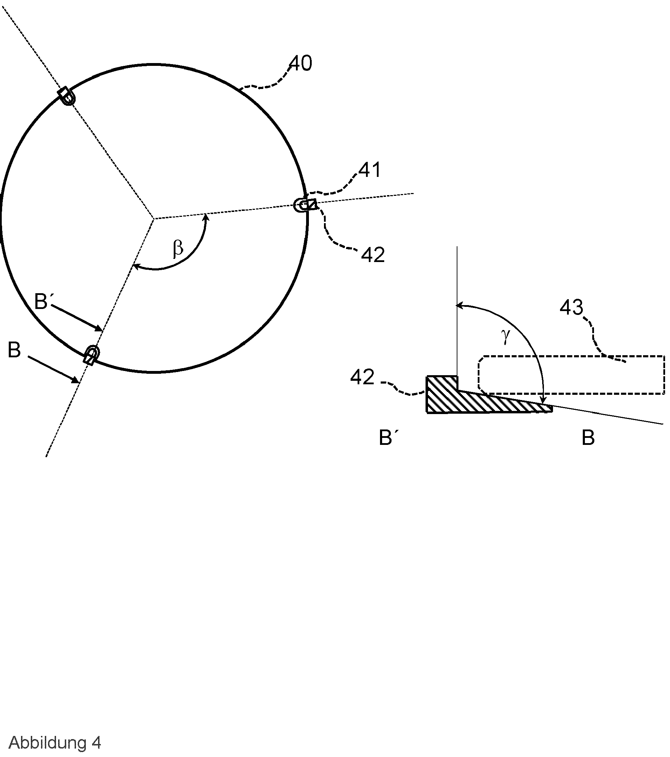

**Abbildung 4** zeigt eine Vorrichtung, auf die während des Markierens die Halbleiterscheibe (**43**) abgelegt wird. Sie enthält eine Grundplatte (**40**) mit einer im wesentlichen kreisförmigen Oberfläche und einer Umfangsfläche. Die Umfangsfläche ist an drei Bereichen durch eine Einbuchtung (**41**) unterbrochen. In den Einbuchtungen ist ein Aufnahmelager (**42**) angebracht, auf dem eine Halbleiterscheibe so abgelegt werden kann, dass sie die Oberfläche der Grundplatte (**40**) nicht berührt.

Der Schnitt **B'-B** zeigt einen Profilschnitt durch ein Aufnahmelager (**42**) das eine Auflagefläche zeigt, auf dem eine Halbleiterscheibe (**43**) abgelegt werden kann. Die Auflagefläche ist dabei um den Absatzwinkel γ gegenüber der Vertikalen geneigt. Bevorzugt misst der Absatzwinkel mehr als 90° und weniger als 135°.

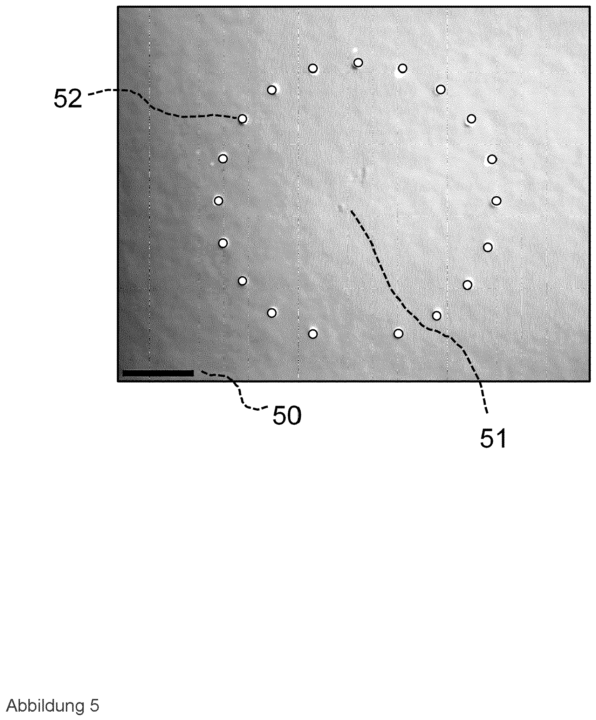

**Abbildung 5** zeigt ein Bild, das mit Hilfe von Lichtmikroskopie aufgenommen wurde und zeigt die Position eines zu untersuchenden Defekts (**51**), die von Referenzmarkierungen (**52**), die unter Verwendung eines Eindrückwerkzeugs entstanden sind, umgeben ist. Das Muster, das die Referenzmarkierungen bilden, ist kreisförmig um die Markierungsstelle angeordnet und einseitig geöffnet. Der Skalierungsbalken (**50**) zeigt eine Länge von 100 µm.

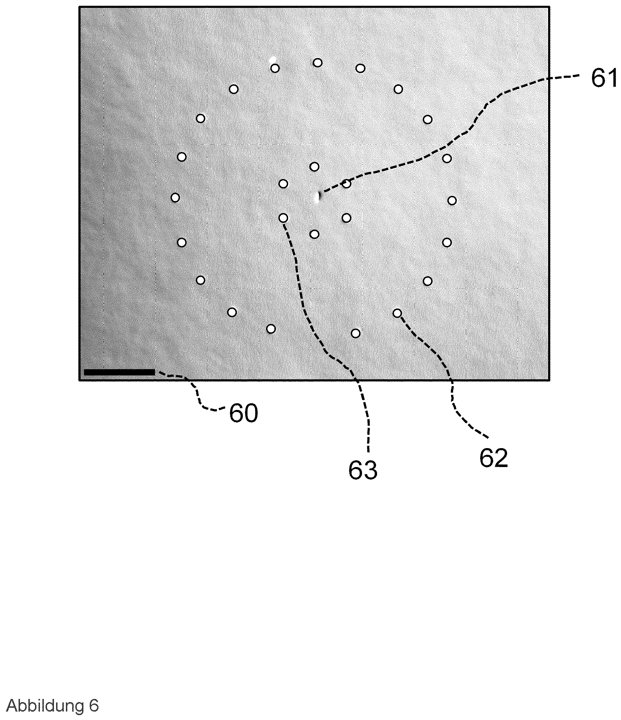

Auch die **Abbildung 6** zeigt ein Bild, das mit Hilfe von Lichtmikroskopie aufgenommen wurde und zeigt die Position eines zu untersuchenden Defekts (**61**), die von Referenzmarkierungen (**62**), die unter Verwendung eines Eindrückwerkzeugs entstanden sind, umgeben ist. Das Muster, das die Referenzmarkierungen bilden, ist kreisförmig um die Markierungsstelle angeordnet und einseitig geöffnet. Zusätzlich sind weitere Referenzmarkierungen (**63**) aufgebracht, die sich in einem kleineren Abstand um die Position des zu untersuchenden Defektes befinden. Der Skalierungsbalken (**60**) zeigt eine Länge von 100 µm.

### Abkürzungen

- 10: Gehäuse
- 11: Station A
- 12: Station B
- 13: Roboterarm zum Transport der Halbleiterscheiben
- 14: Vorrichtung zum Ausrichten der Halbleiterscheibe ("Aligner")
- 15: Vorrichtung zum Markieren der Halbleiterscheibe unter Verwendung eines Eindrückwerkzeugs (Indentierer)
- d: Durchmesser des generierten Defekts an der Oberfläche der Halbleiterscheibe
- α: Öffnungswinkel der Spitze des Eindrückwerkzeugs.
- 20: Halbleiterscheibe, die zum Markieren mittels eines Eindrückwerkzeugs vorgesehen ist.
- 21: Oberfläche der Halbleiterscheibe, die zum Markieren mittels eines Eindrückwerkzeugs vorgesehen ist.
- 22: Spitze des Eindrückwerkzeugs
- 23: Eindrückwerkzeug
- 30: Grundplatte
- 31: erstes profiliertes Kreissegment
- 32: zweites profiliertes Kreissegment
- 33: Vorrichtung, die eine laterale Verschiebung des befestigten profilierten Kreissegments zulässt, um so eine Feinabstimmung auf den Durchmesser der Halbleiterscheibe (34) zu bewirken.
- 34: zu untersuchende Halbleiterscheibe
- 40: Grundplatte zur Vorrichtung zum Markieren der Halbleiterscheibe unter Verwendung eines Eindrückwerkzeugs
- 41: Aussparung der Grundplatte
- 42: Aufnahmelager für eine Halbleiterscheibe
- 43: Halbleitscheibe
- β: Winkel zwischen den Aufnahmepunkten
- γ: Absatzwinkel eines Auflagelagers
- 50: Skalierung eines Bildes der Lichtmikroskopie (entspricht 100µm)
- 51: zu untersuchender Defekt auf der Oberfläche der Halbleiterscheibe
- 52: angebrachte Markierungen unter Verwendung eines Eindrückwerkzeugs.
- 60: Skalierung eines Bildes der Lichtmikroskopie (entspricht 100µm)
- 61: zu untersuchender Defekt auf der Oberfläche der Halbleiterscheibe
- 62: angebrachte Markierungen unter Verwendung eines Eindrückwerkzeugs.
- 63: zusätzlich angebrachte Markierungen unter Verwendung eines Eindrückwerkzeugs.

### Detaillierte Beschreibung und erfindungsgemäße Ausführungsbeispiele

Ein erfindungsgemäßes Verfahren zum Markieren von Defekten auf einer Oberfläche einer Halbleiterscheibe, umfasst die folgenden Schritte:
(1) Das Identifizieren einer Markierungsstelle auf der Oberfläche einer Halbleiterscheibe und
(2) das Markieren einer Oberfläche der Halbleiterscheibe mit einer Vielzahl von Referenzmarkierungen.

Die Markierungsstelle entspricht dabei einer Position eines Defekts auf der Oberfläche der Halbleiterscheibe, die bevorzugt aus Silizium besteht.

Referenzmarkierungen haben wie in **Abbildung 2** gezeigt dabei eine Tiefe **d** und einem Öffnungswinkel α und werden in einem vordefinierten Muster um die Markierungsstelle unter Zuhilfenahme eines Markierungswerkzeuges angebracht.

Die Tiefe d der Referenzmarkierungen ist dabei bevorzugt nicht kleiner ist als 100 nm und nicht größer ist als 1 µm.

Die laterale Ausdehnung der Referenzmarkierungen an der Oberfläche der zu untersuchenden Halbleiterscheibe ist dabei bevorzugt nicht kleiner als 2 µm und nicht größer als 5 µm.

Um die Position eines Defektes (Markierungsstelle) auf der Oberfläche der Halbleiterscheibe zu bestimmen, wird bevorzugt eine Datei verwendet, die diese Daten enthält. Bevorzugt wird die Datei erhalten, indem eine Halbleiterscheibe mittels Techniken der Lichtstreuung untersucht wird und das Ergebnis elektronisch in die Datei gespeichert wird.

Die Markierungsstelle nun kann mit dem zu verwendenden Mikroskop angefahren werden. Vorher ist jedoch darauf zu achten, dass die Halbleiterscheibe ausgerichtet wurde, so dass die Koordinaten in der Defektdatei bestmöglich verwendet werden können. Dies geschieht wie in Abbildung 1 gezeigt in einer dafür geeigneten Vorrichtung.

Bevorzugt wird eine mikroskopische Analyse durchgeführt, die die Schritte (1) Erzeugung eines ersten Bildes und (2) Analysieren des ersten Bildes mit Methoden einer elektronischen Bildverarbeitung enthält. Ein Ziel dabei ist, eine genauere Position des Defektes zu erhalten. Bevorzugt enthält wird das erste Bild mittels eines Rasterkraftmikroskops (AFM) erhalten.

Besonders bevorzugt enthält die mikroskopische Analyse zusätzlich die Erzeugung eines zweiten Bildes, das mittels eines optischen Mikroskops erhalten wurde und das mit Methoden einer elektronischen Bildverarbeitung bearbeitet wird.

Die Erfinder haben erkannt, dass es vorteilhaft ist, wenn die genaue Position des Defektes ermittelt wird, wenn sowohl die Ergebnisse des Analysierens des ersten Bildes als auch des zweiten Bildes herangezogen werden.

Um eine Position auf einer Halbleiterscheibe zu markieren ist es besonders vorteilhaft, ein vordefiniertes Muster von mehreren Referenzmarkierungen auf der Oberfläche der Halbleiterscheibe anzubringen. Das vordefinierte Muster ist dabei bevorzugt kreisförmig um die Markierungsstelle angeordnet und einseitig geöffnet. Die **Abbildungen 5** und **6** zeigen jeweils ein Beispiel eines vordefinierten Musters.

Die Erfinder haben erkannt, dass es vorteilhaft sein kann, die Positionen der aufgebrachten Markierungen mittels Lichtstreuung zu analysieren und zu speichern, um so einfach Positionsdaten der markierten Defekte zu erhalten für weitergehende Untersuchungen zu erhalten. Dabei erweist es sich als besonders vorteilhaft, dass die so markierten Halbleiterscheiben keinerlei zusätzliche (metallische) Kontamination erfahren, wodurch eine sonst drohende Querkontamination der Anlagen vermieden wird.

Eine erfindungsgemäße Vorrichtung zum Anbringen von Markierungen auf einer Oberfläche einer Halbleiterscheibe enthält wie in **Abbildung 1** gezeigt
(1) eine Vorrichtung zur Aufnahme für einer Wafer-Kassette (**11**, **12**),
(2) eine Vorrichtung zum automatischen Transportieren von einzelnen Halbeiterscheiben (**13**), die bevorzugt als Roboterarm ausgeführt
(3) eine Vorrichtung zum Ausrichten einer Halbleiterscheibe und
(4) eine Vorrichtung zum Markieren unter Verwendung eines Eindrückwerkzeugs,

Wie in **Abbildung 4** gezeigt, enthält die Vorrichtung zum Markieren unter Verwendung eines Eindrückwerkzeugs bevorzugt eine Scheibe mit einer im wesentlichen kreisförmigen Oberfläche. Dessen Umfangsfläche ist bevorzugt an drei Bereichen durch jeweils eine Einbuchtung unterbrochen. An diesen Einbuchtungen befindet sich bevorzugt ein Aufnahmelager für eine Halbleiterscheibe, das so angeordnet ist, dass eine aufgelegte Halbleiterscheibe die Scheibe nicht berührt.

Der Schnitt **B'-B** in **Abbildung 4** zeigt einen Profilschnitt durch ein Aufnahmelager (**42**) das eine Auflagefläche zeigt, auf dem eine Halbleiterscheibe (**43**) abgelegt werden kann. Die Auflagefläche ist dabei bevorzugt um den Absatzwinkel γ gegenüber der Vertikalen geneigt. Bevorzugt misst der Absatzwinkel mehr als 90° und weniger als 135°.

Eine bevorzugte Ausprägung eines für das Markieren verwendete Eindrückwerkzeug ist in **Abbildung 2** gezeigt. Das Eindrückwerkzeug weist eine Spitze auf, die einen Winkel α von nicht größer als 160° und nicht kleiner als 120°, bevorzugt nicht größer als 140° und nicht kleiner als 130° misst.

Die Vorrichtung zum automatischen Transportieren enthält bevorzugt -wie in Abbildung 3 gezeigt- zwei profilierte Kreissegmente, deren Profil zu deren gemeinsamen Kreismittelpunkt hin eine Kante und eine Ablagefläche bildet. Diese Ablagefläche fällt zum Kreismittelpunkt hin mit einem Winkel ab.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen sowie Äquivalente durch den Schutzbereich der Ansprüche abgedeckt sein.

## Patentansprüche

1. Verfahren zum Markieren von Defekten auf einer Oberfläche einer Halbleiterscheibe, das die folgenden Schritte umfasst:
Identifizieren einer Markierungsstelle auf der Oberfläche einer Halbleiterscheibe und
Markieren einer Oberfläche der Halbleiterscheibe mit einer Vielzahl von Referenzmarkierungen mit einer Tiefe d und einem Öffnungswinkel α in einem vordefinierten Muster um die Markierungsstelle unter Zuhilfenahme eines Markierungswerkzeuges,
wobei die Markierungsstelle einer Position eines Defekts auf der Oberfläche der Halbleiterscheibe entspricht und
das Identifizieren der Markierungsstelle das Bereitstellen einer Defektdatei, die eine Liste ungefährer Positionen einer Vielzahl von Defekten auf der Halbleiterscheibe beinhaltet, und ein Anfahren eines Objektivs einer ungefähren Position eines Defekts für eine mikroskopische Analyse umfasst,
wobei die mikroskopische Analyse die Schritte (1) Erzeugung eines ersten Bildes und (2) Analysieren des ersten Bildes mit Methoden einer elektronischen Bildverarbeitung, mit dem Ziel, eine genauere Position des Defektes zu erhalten, enthält,
wobei die Erzeugung des ersten Bildes mittels eines Rasterkraftmikroskops (AFM) durchgeführt wird.

2. Verfahren nach Anspruch 1, **dadurch gekennzeichnet, dass**
die mikroskopische Analyse zusätzlich die Erzeugung eines zweiten Bildes mittels eines optischen Mikroskops und die Analyse des zweiten Bildes mit Methoden einer elektronischen Bildverarbeitung enthält.

3. Verfahren nach einem der vorhergehenden Ansprüche, **dadurch gekennzeichnet, dass** die Tiefe der Referenzmarkierungen nicht kleiner ist als 100 nm und nicht größer ist als 1 µm.

4. Verfahren nach einem der vorhergehenden Ansprüche, **dadurch gekennzeichnet, dass** die laterale Ausdehnung der Referenzmarkierungen nicht kleiner sind als 2 µm und nicht größer als 5 µm.

5. Verfahren nach Anspruch 2, **dadurch gekennzeichnet, dass**
zur Ermittlung einer genaueren Position sowohl die Ergebnisse des Analysierens des ersten Bildes als auch des zweiten Bildes herangezogen werden.

6. Verfahren nach einem der vorhergehenden Ansprüche, **dadurch gekennzeichnet, dass** Elemente der Defektdatei mittels Lichtstreuung ermittelt wurden.

7. Verfahren nach einem der vorhergehenden Ansprüche, **dadurch gekennzeichnet, dass** das vordefinierte Muster kreisförmig um die Markierungsstelle angeordnet und einseitig geöffnet ist.

8. Verfahren nach einem der vorhergehenden Ansprüche, **dadurch gekennzeichnet, dass** nach dem Markieren der Halbleiterscheibe mit einer Vielzahl von Referenzmarkierungen die Halbleiterscheibe mittels einer Streulichtmessung analysiert wird.

9. Vorrichtung zum Anbringen von Markierungen auf einer Oberfläche einer Halbleiterscheibe enthaltend
eine Vorrichtung zur Aufnahme für einer Wafer-Kassette,
eine Vorrichtung zum automatischen Transportieren von einzelnen Halbeiterscheiben,
eine Vorrichtung zum Ausrichten einer Halbleiterscheibe
und eine Vorrichtung zum Markieren unter Verwendung eines Eindrückwerkzeugs, **dadurch gekennzeichnet, dass**
die Vorrichtung zum Markieren unter Verwendung eines Eindrückwerkzeugs beinhaltet
eine Scheibe mit einer im wesentlichen kreisförmigen Oberfläche und einer Umfangsfläche,
wobei die Umfangsfläche an drei Bereichen durch jeweils eine Einbuchtung unterbrochen ist,
an der sich ein Aufnahmelager für eine Halbleiterscheibe befindet, das so angeordnet ist, dass eine aufgelegte Halbleiterscheibe die Scheibe nicht berührt.

10. Vorrichtung nach Anspruch 9, **dadurch gekennzeichnet, dass**
das Eindrückwerkzeug eine Spitze aufweist, die einen Winkel α von nicht größer als 160° und nicht kleiner als 120°, bevorzugt nicht größer als 140° und nicht kleiner als 130° misst.

11. Vorrichtung nach Anspruch 9, **dadurch gekennzeichnet, dass**
die Vorrichtung zum automatischen Transportieren zwei profilierte Kreissegmente beinhaltet, deren Profil zu deren gemeinsamen Kreismittelpunkt hin eine Kante und eine Ablagefläche bildet, wobei die Ablagefläche zum Kreismittelpunkt hin mit einem Winkel abfällt.

## Geänderte Patentansprüche

### Geänderte Patentansprüche gemäss Regel 137(2) EPÜ.

1. Vorrichtung zum Anbringen von Markierungen auf einer Oberfläche einer Halbleiterscheibe enthaltend
eine Vorrichtung zur Aufnahme für einer Wafer-Kassette,
eine Vorrichtung zum automatischen Transportieren von einzelnen Halbeiterscheiben,
eine Vorrichtung zum Ausrichten einer Halbleiterscheibe
und eine Vorrichtung zum Markieren unter Verwendung eines Eindrückwerkzeugs, **dadurch gekennzeichnet, dass**
die Vorrichtung zum Markieren unter Verwendung eines Eindrückwerkzeugs beinhaltet
eine Scheibe mit einer im wesentlichen kreisförmigen Oberfläche und einer Umfangsfläche,
wobei die Umfangsfläche an drei Bereichen durch jeweils eine Einbuchtung unterbrochen ist,
an der sich ein Aufnahmelager für eine Halbleiterscheibe befindet, das so angeordnet ist, dass eine aufgelegte Halbleiterscheibe die Scheibe nicht berührt.

2. Vorrichtung nach Anspruch 1, **dadurch gekennzeichnet, dass** die Vorrichtung zum automatischen Transportieren zwei profilierte Kreissegmente beinhaltet, deren Profil zu deren gemeinsamen Kreismittelpunkt hin eine Kante und eine Ablagefläche bildet, wobei die Ablagefläche zum Kreismittelpunkt hin mit einem Winkel abfällt.
